# EUROPEAN PATENT SPECIFICATION

(11) **EP 4 530 248 B1**
(45) Date of publication and mention of the grant of the patent: **22.07.2026**
(21) Application number: 23200277.4
(22) Date of filing: 28.09.2023
(51) Int. Cl.: B81B 5/00, B81C 1/00

(54) **MEMS STRUCTURES WITH GAPS**
MEMS-STRUKTUREN MIT LÜCKEN
STRUCTURES MEMS À ESPACES

(43) Date of publication of application: 02.04.2025
(73) Proprietor: Murata Manufacturing Co., Ltd., Nagaokakyo-shi, Kyoto 617-8555 (JP)
(72) Inventor: PARTANEN, Mikko, 01710 Vantaa (FI); HANNULA, Konsta, 04130 Sipoo (FI)
(74) Representative: Boco IP Oy Ab

(56) References cited:
- US-B2- 11 137 250
- YONGFENG GAO ET AL: "Electrostatic comb-drive actuator for MEMS relays/switches with double-tilt comb fingers and tilted parallelogram beams", JOURNAL OF MICROMECHANICS AND MICROENGINEERING, INSTITUTE OF PHYSICS PUBLISHING, BRISTOL, GB, vol. 25, no. 4, 24 February 2015 (2015-02-24), pages 45003, XP020281914, ISSN: 0960-1317, [retrieved on 20150224], DOI: 10.1088/0960-1317/25/4/045003

## Description

### FIELD OF THE DISCLOSURE

The present disclosure relates to MEMS structures, and particularly to MEMS structures with active comb gaps.

### BACKGROUND OF THE DISCLOSURE

MEMS structures, such as active comb structures of electrostatic actuators, often comprise areas where the abrupt change in an aspect ratio is present. Such MEMS structures are commonly fabricated using Deep Reactive Ion Etching (DRIE). One problem which arises when etching the design locations with the abrupt change in the aspect ratio and where the dimensions are close to critical values is Aspect Ratio Dependent Etching (ARDE). ARDE may cause striation and side wall defects, which compromise a geometry of the processed structure, may generate loose silicon particles, and reduce signal quality.

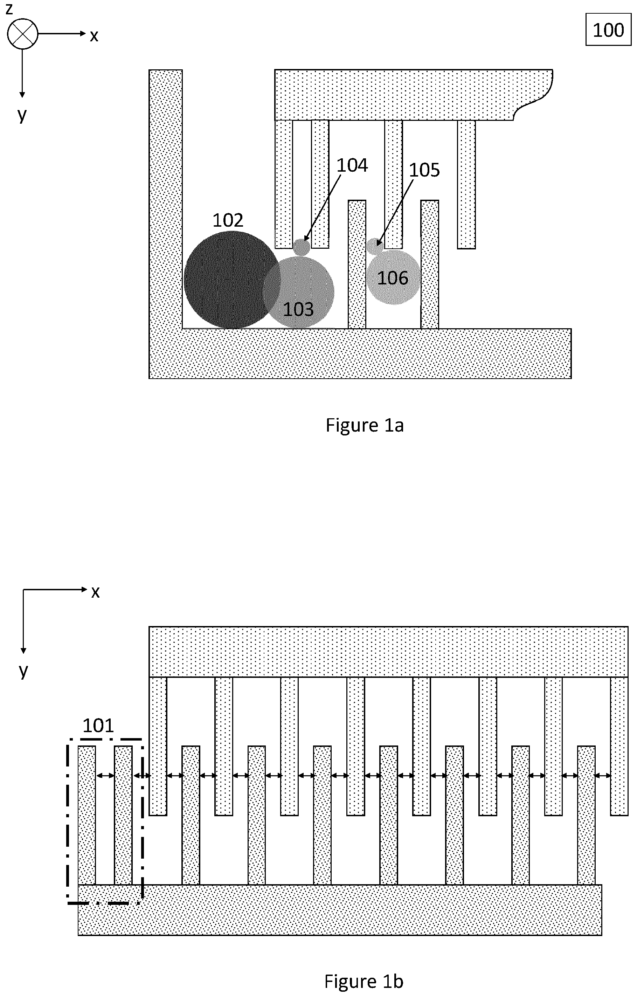

An example of the structure with areas, where the abrupt change of the aspect ratio is present, is illustrated in Figure 1a. An exemplar comb structure 100 comprises connected open areas 102, 103 and 104. The aspect ratio may be defined as the relation of dimension of the height in a z-direction to that of the surface in a x/y-direction. The region, where the areas 102-103 and the area 104 with notable difference of the widths merge, may be where the abrupt change of the aspect ratio is present. The ARDE effect in such regions may be especially concerning if the width of the smallest area 104 is in the critical values range. In contrast, areas 105 and 106 have smaller difference in their widths, thus the change of the aspect ratio in this region may not be characterized as abrupt.

One way to avoid ARDE effect is to add a shielding structure 101 into the design, as illustrated in Figure 1b. The shielding structure helps to keep the gradient of the aspect ratio in control and/or move the damage of DRIE from active MEMS structure to the shielding structure. The disadvantage of such solution is that the shielding structure require extra design space in the MEMS structure. Thus, the solution for eliminating ARDE effect without compromising design space is desired.

The publication Gao et al, Electrostatic comb-drive actuator for MEMS relays/switches with double-tilt comb fingers and tilted parallelogram beams, Journal of micromechanics and microengineering, vol. 25, no. 4, Feb 2015, page 45003, discloses an electrostatic drive with fixed electrodes and movable electrodes where comb fingers have a tilted shape.

### BRIEF DESCRIPTION OF THE DISCLOSURE

An object of the present disclosure is to provide a new design of a MEMS structure so as to solve the above problem.

The object of the disclosure is achieved by an arrangement which is characterized by what is stated in the independent claim. The preferred embodiments of the disclosure are disclosed in the dependent claims.

The disclosure is based on the idea of a stator and a rotor forming a structure, wherein a gap between the stator and the rotor is gradually increasing in at least part of the structure where an abrupt change in the aspect ratio is expected.

An advantage of the arrangement of the disclosure is that undesired ARDE effect is eliminated, and high-quality MEMS structures are achieved.

### BRIEF DESCRIPTION OF THE DRAWINGS

In the following the disclosure will be described in greater detail by means of preferred embodiments with reference to the accompanying drawings, in which:
Figure 1a illustrates an example of structure with abrupt change of an aspect ratio not part of the invention;
Figure 1b illustrates an example of a MEMS design with a shielding structure based on the prior art;
Figure 2a illustrates a MEMS structure of this disclosure with a stator and a rotor;
Figure 2b illustrates the MEMS structure with an interdigitated row formed by pairs of adjacent stator and rotor fingers;
Figure 2c illustrates the MEMS structure with an end portion of the interdigitated row and a central portion of the interdigitated row;
Figure 2d illustrates the MEMS structure with gradually decreasing widths of x-gaps in the end portion of the interdigitated row;
Figure 3a illustrates a MEMS structure with first y-gaps and second y-gaps;
Figure 3b illustrates the MEMS structure with the first and the second y-gaps in the end portion of the interdigitated row;
Figure 4a illustrates a MEMS structure with the second end portion and x-gaps;
Figure 4b illustrates the MEMS structure with the second end portion, x-gaps and y-gaps;
Figure 5 illustrates a MEMS structure not part of the invention with a stator and a rotor forming a parallel plates structure, and regions where the aspect ratio change is present;
Figure 5a illustrates an embodiment of the MEMS structure not partof the invention with a stator and a rotor forming a parallel plates structure;
Figure 5b illustrates an embodiment of the MEMS structure not part of the invention with a first end, a second end, and a central portion of the parallel plates structure;
Figure 5c illustrates an embodiment of the MEMS structure not part of the invention with the stator and the rotor forming the parallel plates structure.

### DETAILED DESCRIPTION OF THE DISCLOSURE

The disclosure concerns MEMS structures, and in particular MEMS structures that comprise combs, bumps or other microstructures with high aspect ratio. As was described above, the MEMS structures may be produced with Deep Reactive Ion Etching (DRIE) technique. The MEMS structures with dimensions close to critical values tend to suffer from Aspect Ratio Dependent Etching (ARDE) during DRIE, which negatively affects the quality of the fabricated structures. The areas, which ARDE effect affects the most, are most commonly in the places where the abrupt change of aspect ratio occurs such as where the wide-open areas connect with significantly more narrow open areas. Figure 1a illustrates exemplary structure with the abrupt change of the aspect ratio when the areas 102-103 merge with the area 104.

This disclosure presents a solution for improving quality of such areas. The ARDE effect may be minimized by gradually decreasing the dimensions of the etched structures from larger, where the change of the aspect ratio is the largest, to smaller where the change of the aspect ratio is the smallest. The details of the invention are described below. Although the embodiments of this disclosure primarily illustrate comb structures of an electrostatic actuator, the same idea may be applied to other MEMS structures with dimensions close to critical values and where the abrupt change of aspect ratio is present.

A MEMS structure according to claim 1 of this disclosure comprises
o a stator which comprises a stator element and a row of stator comb fingers, wherein the stator comb fingers extend away from the stator element in a y-direction,
o a rotor which comprises a rotor element and a row of rotor comb fingers, wherein the rotor comb fingers extend away from the rotor element in the direction which is opposite to the y-direction,
and wherein
o the stator comb fingers are interdigitated with the rotor comb fingers, and form an interdigitated row,
o and each pair of the adjacent stator comb finger and rotor comb finger is separated from each other by a x-gap in a x-direction, which is perpendicular to the y-direction,
and wherein
o the interdigitated row comprises an end portion,
o and the interdigitated row comprises a central portion, and the central portion and the end portion are next to each other,
o and the width of the x-gaps in the central portion has a constant value,
o and the widths of the x-gaps in the end portion gradually decrease in the end portion of the interdigitated row, so that the width of the endmost x-gap in the end portion of the interdigitated row is the largest.

### Stator and rotor

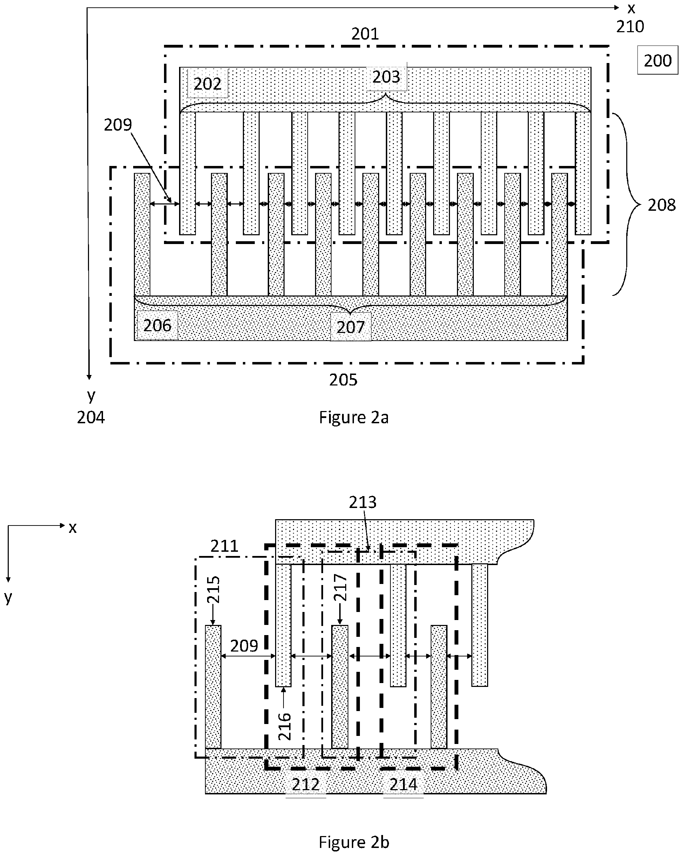

A MEMS structure 200 of this disclosure comprises a stator 201 as illustrated in Figure 2a. The stator 201 is a part of the MEMS structure 200 which is fixed. In other words, the stator 201 is a static part which does not move in relation to a surrounding device package when a MEMS device is in use. The stator 201 may comprise a stator element 202. The stator element 202 may be connected to other static part of the MEMS structure 200. The stator 201 further comprises stator comb fingers 203 which extend away from the stator element 202. The stator comb fingers 203 may define a y-direction 204. The stator comb fingers 203 may extend parallel to the y-direction 204. The stator comb fingers 203 may point to the y-direction 204. The y-direction 204 may alternatively be called a transverse direction.

The MEMS structure 200 of this disclosure further comprises a rotor 205. The rotor 205 is a part of the MEMS structure 200 which may move in relation to the stator 201, and in relation to the surrounding device package when the MEMS device is in use. In other words, the rotor 205 is a dynamic part of the MEMS structure 200. The rotor 205 may comprise a rotor element 206. The rotor element 206 may be, for example, a beam connected to the moving parts of the MEMS structure 200. The rotor 205 further comprises rotor comb fingers 207 which extend away from the rotor element 206 parallel to the y-direction 204. The rotor comb fingers 207 may point to the opposite to the y-direction 204. In other words, the stator and the rotor comb fingers 203 and 207 are pointing to the opposite directions. In other words, the rotor comb fingers 207 may point to the stator element 202. The stator comb fingers 203 may point to the rotor element 206.

### Interdigitated row and the gap

The stator comb fingers 203 are interdigitated with the rotor comb fingers 207. The stator comb fingers 203 and the rotor comb fingers 207 form an interdigitated row 208.

Each pair of the adjacent stator comb finger and rotor comb finger is separated from each other by a x-gap in a x-direction 210. Figures 2a-b illustrate the first x-gap 209. The x-direction 210 is perpendicular to the y-direction 204. The x-direction 210 may alternatively be called a longitudinal direction. Thus, the x-gap may alternatively be called a longitudinal gap. The x-gaps between each pair of the adjacent stator comb finger and rotor comb finger extend in the x-direction 210 and are indicated with arrows in Figure 2a.

The pairs of the adjacent stator comb finger and rotor comb finger are illustrated in more detail in Figure 2b. Four pairs 211-214 are illustrated for exemplary purpose. Each of the adjacent stator comb finger and rotor comb finger may form second finger of one or two pairs. Specifically, the static comb finger 216 may form one pair 211 with the rotor comb finger 215, and another pair 212 with rotor comb finger 217.

### Rotor movement

The rotor 205 may be configured to move in relation to the stator 201. The rotor 205 may be configured to move linearly along the x-direction 210. Specifically, the rotor 205 may be configured to move in the x-direction 210 and opposite to the x-direction 210.

In some embodiments of this disclosure, the rotor 205 may be configured to move linearly along the y-direction 204. Specifically, the rotor 205 may be configured to move in the y-direction 204 and opposite to the y-direction 204. Alternatively, the rotor 205 may be configured to move linearly along the x-direction 210 and along the y-direction 204.

Alternatively, the rotor 205 may be configured to move linearly along a z-direction (not illustrated). The z-direction may be orthogonal to the x- and y-directions.

### Portions of the interdigitated row

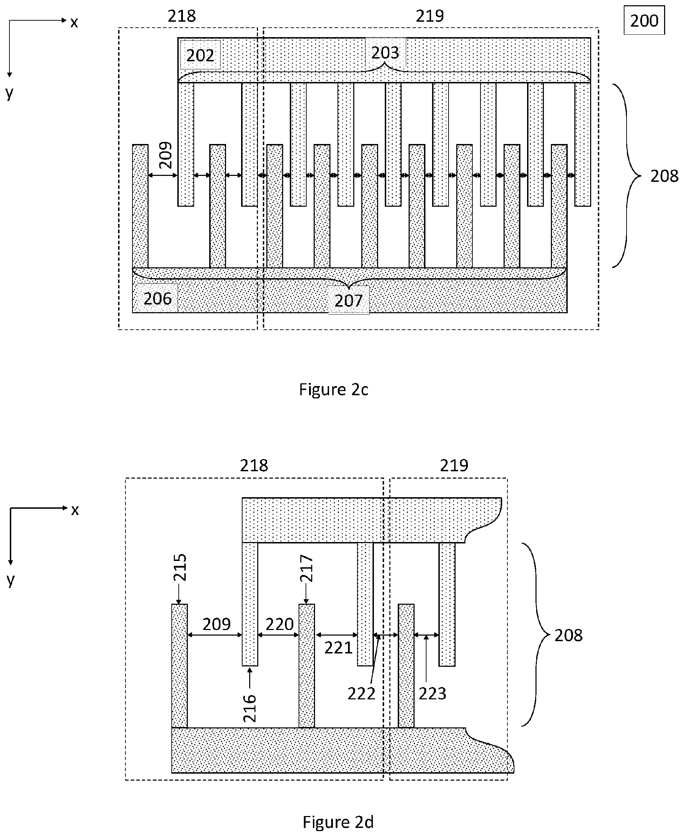

The interdigitated row comprises an end portion 218 as illustrated in Figure 2c. The end portion 218 may comprise at least the first two pairs of the adjacent stator comb finger and rotor comb finger. In other words, the end portion 218 may comprise at least three comb fingers: two stator comb fingers and one rotor comb finger. Alternatively, the end portion 218 may comprise at least three comb fingers: one stator comb finger and two rotor comb fingers. Alternatively, the end portion 218 may comprise at least four comb fingers, at least five comb fingers, at least six comb fingers.

The interdigitated row also comprises a central portion 219. The central portion 219 may comprise other pairs of the adjacent stator comb fingers and rotor comb fingers. In other words, the central portion 219 may comprise the comb fingers of the interdigitated row 208 except the at least three first fingers of the end portion 218. Specifically, the central portion 219 may comprise more comb fingers than the end portion 218 comprises. For example, the central portion 219 may comprise more than 10, more than 20, more than 40, more than 50 comb fingers of the interdigitated row 208. The central portion 219 is adjacent to the end portion 218.

### Width of the x-gaps

The widths of the x-gaps in the end portion 218 are illustrated in detail in Figure 2d. The x-gaps in the end portion of the interdigitated row 208 may be 209 and 220-221. The widths of the x-gaps in the end portion gradually decrease in the end portion of the interdigitated row, so that the width of an endmost x-gap in the end portion of the interdigitated row is the largest. The endmost x-gap in the end portion of the interdigitated row is the x-gap 209.

In other words, the widths of the x-gaps in the end portion 218 may be gradually decreasing as the x-coordinate increases in the x-direction from a first comb finger of the interdigitated row. The first comb finger of the interdigitated row may be the rotor comb finger, such as 215 in Figure 2d. Alternatively, the first comb finger of the interdigitated row may be the static comb finger (not illustrated). The first comb finger of the interdigitated row has the smallest x-coordinate. The width of the x-gap 209 in the end portion 218 may be greater than the width of the x-gap 220. The width of the x-gap 220 in the end portion 218 may be greater than the width of the x-gap 221. And the width of the x-gap 221 in the end portion 218 may be greater than the width of the x-gap 222.

The gradual change of the width of the x-gaps may be from larger values in places where the aspect ratio is smaller to smaller values close to critical dimensions where aspect ratio is larger. Such gradual change of the width of the x-gaps may eliminate ARDE effect discussed above and improve geometry of the etched structures.

The MEMS structure, wherein a ratio between the largest and the smallest widths of the x-gap is more than 125%.

The exemplary width of the x-gap 209 may be 5 - 8 um. The exemplary width of the x-gaps 220-221 may be 2.5 - 3 um. The exemplary width of the x-gaps 222-223 may be 2 - 2.5 um. In other words, the width of the x-gaps in the end portion 218 may gradually decrease from, for example, 8 um to 2 um. In other words, the ratio between the largest width of the x-gap and the smallest width of the x-gap in the end portion may be 4:1. Thus, the width of the x-gaps in the end portion 218 may gradually decrease four times. In general, the ratio between the largest width of the x-gap and the smallest width of the x-gap in the end portion may be more than 125%.

The x-gaps in the central portion 219 of the interdigitated row 208 may be, for example, 222-223 illustrated in Figure 2d. The widths of the x-gaps in the central portion 219 have constant value. In other words, the widths of the x-gaps in the central portion 219 are not changing when the x-coordinate is changing. Specifically, the width of the x-gap 222 in the central portion 219 may be equal to the width of the x-gap 223.

The exemplary width of the x-gaps in the central portion may be 2 um. In other words, the ratio between the largest width of the x-gap in the end portion and the width of the x-gaps in the central portion may be 4:1.

In general, the minimal width of the x-gaps of this disclosure may be close to the critical dimension of the DRIE process. The critical dimension may for example be 2 um.

The MEMS structure, wherein each stator comb finger and the opposite rotor element are separated from each other by a first y-gap in the y-direction, and each rotor comb finger and the opposite stator element are separated from each other by a second y-gap in the y-direction, and the widths of the first and the second y-gaps gradually decrease in the end portion of the interdigitated row, so that the width of the endmost first or the second y-gap in the end portion of the interdigitated row is the largest, and the widths of the first and the second y-gaps have a constant value in the central portion of the interdigitated row.

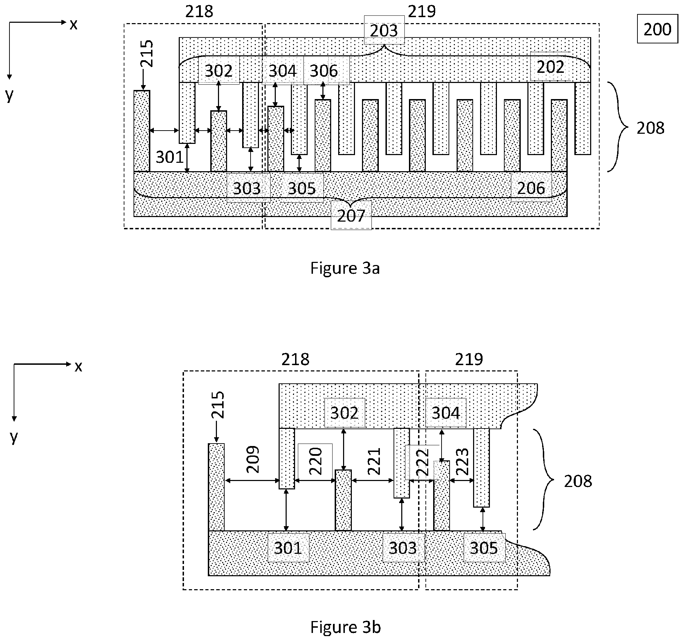

Figure 3a illustrates a first embodiment of the MEMS structure 200 of this disclosure. In this embodiment, a y-gap may be defined between each stator or rotor finger and the opposing rotor or stator element. Specifically, a first y-gap may be defined between each static comb finger and the opposite rotor element along the y-direction, such as y-gaps 301, 303 and 305 in Figure 3a. A second y-gap may be between each rotor comb finger and the opposite stator element along the y-direction, such as y-gaps 302 and 304 and 306 in Figure 3a. The first and the second y-gaps may alternatively be called the first and the second transverse gaps.

Figure 3b illustrates the end portion 218 and part of the central portion 219 of this embodiment in more detail. The widths of the first and the second y-gaps gradually decrease in the end portion of the interdigitated row, so that the width of an endmost first or the second y-gap in the end portion of the interdigitated row is the largest. The endmost first y-gap in Figure 3b is the first y-gap 301. In other words, the width of the first and the second y-gaps 301-305 in the y-direction in the end portion 218 of the interdigitated row 208 may be gradually decreasing when the x-coordinate is increasing from the first stator or rotor comb finger of the interdigitated row 208, such as the first rotor comb finger 215.

The width of the first and the second y-gaps 301-305 in the y-direction in the central portion 219 may have constant value. In other words, the width of the first and the second y-gaps 301-305 in the central portion 219 may be staying constant when the x-coordinate is increasing from the first stator or rotor comb finger of the interdigitated row 208, such as the first rotor comb finger 215.

The MEMS structure, wherein a ratio between the largest and the smallest widths of the first and the second y-gap is more than 125%.

The exemplary width of the first and the second y-gaps in the end portion may be 2.5 - 10 um. Specifically, the width of the first and the second y-gaps 301 and 302 may be 3.5 um. The width of the first and the second y-gaps 303 and 304 may be 3 um. The width of the first and the second y-gaps 305 and 306 may be 2.5 um. The exemplary width of the first and the second y-gaps in the central portion may be 2 - 6 um. The exemplary width of the first and the second y-gaps in the central portion may be 2 um. In other words, the ratio between the largest width of the first and the second y-gaps in the end portion and the width of the first and the second y-gaps in the central portion may be 1.75 : 1. In general, the ratio between the largest width of the first and the second y-gaps in the end portion and the width of the first and the second y-gaps in the central portion may be more than 125%.

In the embodiment of Figures 3a-b, the width of the both the x-gaps and the y-gaps in the end portion 218 may be gradually decreasing when x-coordinate is increasing in the x-direction from the first stator or rotor comb finger of the interdigitated row 208, such as the first rotor comb finger 215. In other words, the width of the gaps between the adjacent elements of the MEMS structure may be gradually decreasing when the x-coordinate is increasing from the beginning of the end portion 218 towards the central portion 219. Specifically, the width of the x-gap 209 in the end portion 218 may be greater than the width of the x-gap 220. The width of the x-gap 220 in the end portion 218 may be greater than the width of the x-gap 221. And the width of the x-gap 221 in the end portion 218 may be greater than the width of the x-gap 222.

Similarly, the width of the first y-gap 301 in the end portion 218 may be greater than the width of the first y-gap 303. The width of the first y-gap 303 in the end portion 218 may be greater than the width of the first y-gap 305. And the width of the second y-gap 302 in the end portion 218 may be greater than the width of the second y-gap 304. Further, the width of the first y-gap 301 in the end portion 218 may be equal to the width of the second y-gap 302. And the width of the first y-gap 303 in the end portion 218 may be equal to the width of the second y-gap 304.

The MEMS structure, wherein the interdigitated row comprises a second end portion with at least two last pairs of the adjacent stator comb fingers and rotor comb fingers, and wherein the second end portion is next to the central portion, and wherein the widths of the x-gap gradually decrease in the second end portion of the interdigitated row, so that the width of the endmost x-gap in the second end portion of the interdigitated row is the largest.

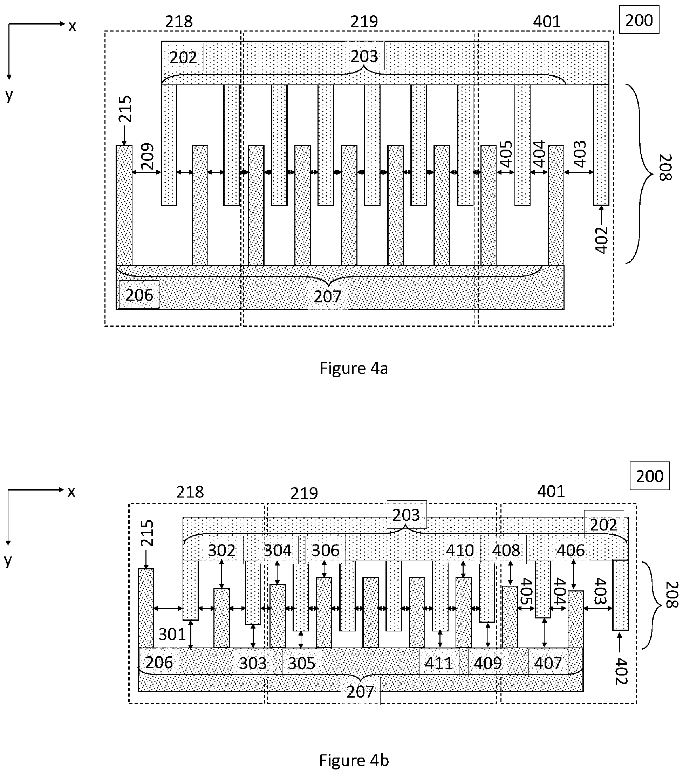

The second embodiment of this disclosure is illustrated in Figure 4a. The MEMS structure 200 may comprise a second end portion 401. The second end portion 401 may comprise at least two last pairs of the adjacent stator comb fingers and rotor comb fingers. In other words, the second end portion 401 may be at the end of the interdigitated row starting from where the x-coordinate is maximal. A last comb finger may be defined as the stator or rotor comb finger which has the greatest x-coordinate of the interdigitated row 208. The last comb finger may, for example, be the stator comb finger 402 as defined in the Figure 4a.

As Figure 4a illustrates, the widths of the x-gap may be gradually decreasing in the second end portion of the interdigitated row, so that the width of an endmost x-gap in the second end portion of the interdigitated row is the largest. The endmost x-gap in the second end portion of the interdigitated row is 403. The width of the x-gap in the second end portion 401 may be gradually decreasing when x-coordinate is decreasing from its maximum, which corresponds to the last comb finger 402, towards the central portion 219. Specifically, the width of the x-gaps 403-405 may be gradually decreasing. The width of the x-gap 403 may be greater than the width of the x-gap 404. The width of the x-gap 404 in the second end portion 401 may be greater than the width of the x-gap 405.

The MEMS structure, wherein the widths of the first and the second y-gaps gradually decrease in the second end portion of the interdigitated row, so that the width of the endmost first or second y-gap in the second end portion of the interdigitated row is the largest.

Figure 4b illustrates the third embodiment of the disclosed MEMS structure 200. As in the previous embodiment, the MEMS structure 200 may comprise the second end portion 401. The second end portion 401 may comprise at least two last pairs of the adjacent stator comb fingers and rotor comb fingers. In other words, the second end portion 401 may be at the end of the interdigitated row starting from where the x-coordinate is maximal. The last comb finger may be defined as the stator or rotor comb finger which has the greatest x-coordinate of the interdigitated row 208. The last comb finger may, for example, be the stator comb finger 402 as defined in the Figures 4a-b.

As Figure 4b illustrates, the widths of the first and the second y-gaps may be gradually decreasing in the second end portion of the interdigitated row, so that the width of an endmost first or second y-gap in the second end portion of the interdigitated row is the largest. The endmost second y-gap in the second end portion of the interdigitated row may be the second y-gap 403. In other words, the widths of the first y-gaps (407, 409, 411) and the second y-gaps (406, 408, 410) in the second end portion 401 may be gradually decreasing when x-coordinate is decreasing from its maximum, which corresponds to the last comb finger 402, towards the central portion 219.

Specifically, the width of the first and the second y-gaps 406-411 may be gradually decreasing. The width of the first y-gap 406 in the second end portion 401 may be greater than the width of the first y-gap 408. The width of the first y-gap 408 in the second end portion 401 may be greater than the width of the first y-gap 410. Further, the width of the second y-gap 407 in the second end portion 401 may be greater than the width of the second y-gap 409. The width of the second y-gap 409 in the second end portion 401 may be greater than the width of the second y-gap 411. Additionally, the width of the first y-gap 406 in the second end portion 401 may be equal to the width of the second y-gap 407. The width of the first y-gap 408 in the second end portion 401 may be equal to the width of the second y-gap 409.

### Parallel plates structure

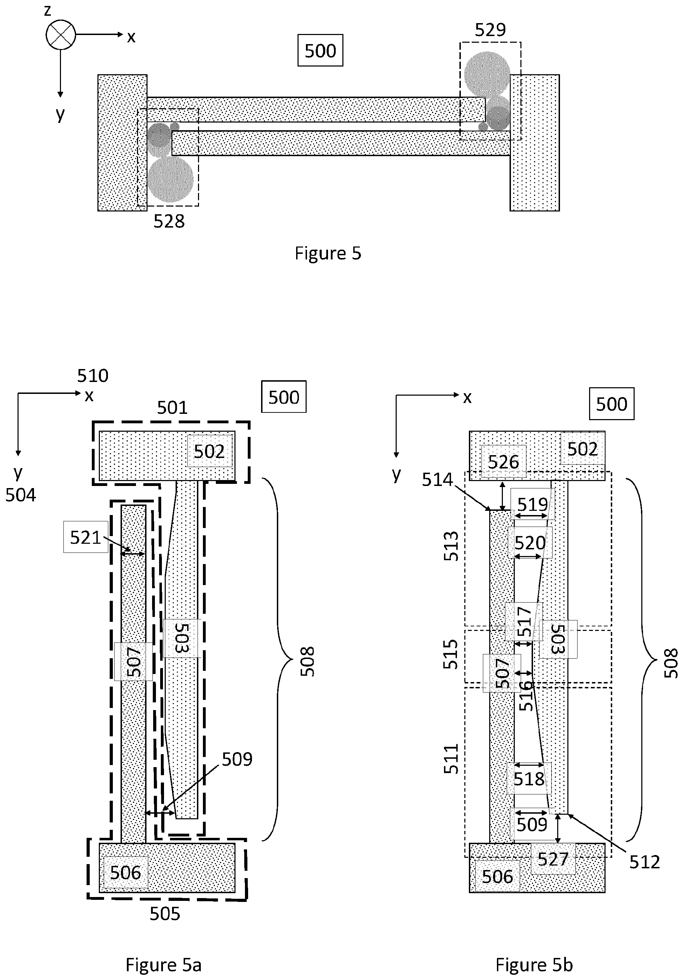

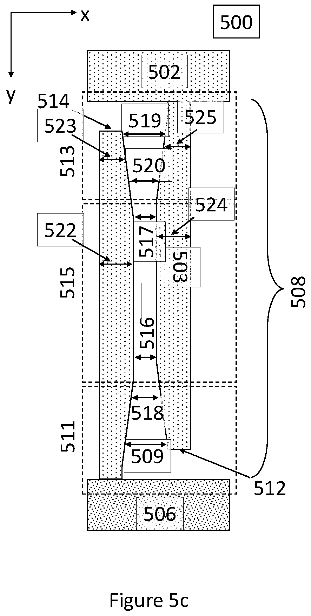

The abrupt change of the aspect ratio, where the large open areas are next to the narrow gaps, may also exist in other rotor and stator arrangements. For example, the rotor and the stator in the form of parallel plates may be arranged into a parallel plate electrostatic actuator. Alternatively, the rotor and the stator may be separated by the bump structure which forms a narrow gap and contributes to the abrupt change of the aspect ratio. Figure 5 illustrates the regions 528 and 529 where wide open areas (larger circles) are merging with more narrow open area (smallest circle). The ARDE effect in such regions may be especially concerning if the width of the smallest area (diameter of the smallest circle) is in the critical values range. Thus, gradual increase of the aspect ratio in these regions, as described below, may eliminate undesired striation and side wall defects.

An example of a MEMS structure of this disclosure not part of the invention may comprise
- a stator which comprises a stator element and at least one stator comb plate, wherein the stator comb plate extends away from the stator element in a y-direction,
- a rotor which comprises a rotor element and at least one rotor comb plate, wherein the rotor comb plate extends away from the rotor element in a direction which is opposite to the y-direction,
and wherein
- the stator comb plate and the rotor comb plate are parallel to each other, and the stator comb plate and the rotor comb plate form a parallel plates structure,
- and the stator comb plate and the rotor comb plate are separated from each other by a x-gap in a x-direction which is perpendicular to the y-direction,
and wherein
- the parallel plates structure comprises a first end portion which comprises at least an end of the stator comb plate,
- the parallel plates structure comprises a second end portion which comprises at least an end of the rotor comb plate,
- and the parallel plates structure comprises a central portion which comprises areas of the parallel plates structure between the ends of the stator and the rotor, and the central portion is between the first end portion and the second end portion,
- and the width of the x-gap in the central portion has a constant value,
- and the width of the x-gap in the first end portion gradually decreases so that the width of the x-gap in the first end portion is the largest where the rotor comb plate is attached to the rotor element,
- and width of the x-gap in the second end portion gradually decreases, so that the width of the x-gap in the second end portion is the largest where the stator comb plate is attached to the stator element.

A MEMS structure 500 of this disclosure not part of the invention comprises a stator 501. The stator 501 comprises a stator element 502 and at least one stator comb plate 503. The stator comb plate 503 extends away from the stator element 502 in a y-direction 504. The MEMS structure 500 of this disclosure further comprises a rotor 505. The rotor 505 comprises a rotor element 506 and at least one rotor comb plate 507. The rotor comb plate 507 extends away from the rotor element 506 in the opposite to the y-direction 504.

The stator comb plate 503 and the rotor comb plate 507 are parallel to each other. The stator comb plate 503 and the rotor comb 507 plate form a parallel plates structure 508. The stator comb plate 503 and the rotor comb plate 507 are separated from each other by a x-gap (such as 509) in a x-direction 510. The x-direction 510 is perpendicular to the y-direction 504.

The parallel plates structure 508 comprises a first end portion 511 as illustrated in Figure 5b. The first end portion 511 comprises at least an end the stator comb plate 512. The end of the stator comb plate 512 may be defined as the outermost edge of the stator comb plate 503 which faces the rotor element 506. The length of the first end portion 511 in the y-direction may occupy 1% - 45% of the length of the parallel plates structure 508 in the y-direction. The first end portion 511 may occupy less than 45%, less than 35%, less than 25% of the parallel plates structure 508.

The parallel plates structure 508 further comprises a second end portion 513. The second end portion 513 comprises at least an end the rotor comb plate 514. The end of the rotor comb plate 514 may be defined as the outermost edge of the rotor comb plate 507 which faces the stator element 502. The second end portion 513 may occupy 1% - 45% of the parallel plates structure 508. The second end portion 513 may occupy less than 45%, less than 35%, less than 25% of the parallel plates structure 508.

The parallel plates structure 508 further comprises a central portion 515 which comprises areas of the parallel plates structure 508 between the ends of the stator and the rotor 512 and 514, and the central portion 515 is between the first end portion 511 and the second end portion 513. The length of the central portion 515 in the y-direction may occupy 10% - 98% of the length of the parallel plates structure 508 in the y-direction. The central portion 515 may occupy more than 10%, more than 20%, more than 50%, more than 75% of the parallel plates structure 508.

A width of the x-gap in the central portion, such as 516-517 in Figure 5b, has a constant value. In other words, the width 516-517 of the x-gap in the central portion may be staying constant when the y-coordinate is changing. Specifically, the width of the x-gap in the central portion, such as 516-517, may be 2 um.

The width of the x-gap in the first end portion may be gradually decreasing, so that the width of the x-gap in the first end portion is the largest where the rotor comb plate is attached to the rotor element. The width of the x-gap in the first end portion where the rotor comb plate is attached to the rotor element may be 509. In other words, the widths 509 and 518 of the x-gap in the first end portion 511 may gradually decrease when y-coordinate decreases from a beginning of the first end portion towards the central portion 515. The beginning of the first end portion 511 is the point where the rotor comb plate 507 is attached to the rotor element 506. The beginning of the first end portion 511 is also where the y-coordinate is maximal. In other words, the width of the x-gap 509 may be greater than the width of the x-gap 518. And the width of the x-gap 518 may be greater than the width of the x-gaps 516-517 in the central portion 515. An exemplary width of the x-gap 509 may be 4 um. Thus, the ratio of the width of the widest x-gap in the first end portion 511 to the narrowest x-gap 516-517 may be 2:1.

The width of the x-gap in the second end portion may be gradually decreasing, so that the width of the x-gap in the second end portion is the largest where the stator comb plate is attached to the stator element. The width of the x-gap in the second end portion where the stator comb plate is attached to the stator element may be 519. In other words, the width of the x-gap in the second end portion 513, such as x-gaps 519-520, gradually decreases when y-coordinate increases from a beginning of the second end portion 513 towards the central portion 515. The beginning of the second end portion 513 is the point 521 where the stator comb plate 503 is attached to the stator element 502 where the y-coordinate is minimal. In other words, the width of the x-gap 519 may be greater than the width of the x-gap 520. And the width of the x-gap 520 may be greater than the width of the x-gaps 516-517 in the central portion 515. An exemplary width of the x-gap 519 may be 4 um. Thus, the ratio of the width of the widest x-gap in the second end portion 513 to the narrowest x-gap 516-517 may be 2:1.

The rotor 505 may be configured to move in relation to the stator 501. The rotor 505 may be configured to move linearly along the x-direction 510. Specifically, the rotor 505 may be configured to move in the x-direction 510 and opposite to the x-direction 510.

The width 521 of the rotor comb plate 507 may be uniform throughout its length as in Figures 5a - 5b. Alternatively, the width of the rotor comb plate 507 may be non-uniform throughout its length as in Figure 5c. For example, the width 522 of the rotor comb plate in the central portion 515 may be greater than the width 523 of the rotor comb plate in the first 511 or the second 513 end portions. Similarly, the width of the stator comb plate 503 may be non-uniform throughout its length as in Figures 5a - 5c. For example, as Figure 5c illustrates, the width 524 of the stator comb plate in the central portion 515 may be greater than the width 525 of the stator comb plate in the first 511 or the second 513 end portions. Alternatively, the width of the stator comb plate 503 may be uniform throughout its length (not illustrated).

A gap 527 between the end 512 of the stator comb plate 503 and the rotor element 506 may be equal to the x-gap 509 in the first end portion 511, as Figure 5b illustrates. Similarly, a gap 526 between the end 514 of the rotor comb plate 507 and the stator element 502 may be equal to the x-gap 519 in the second end portion 513. Further, the gaps 526 and 527 may be greater than the x-gaps 516-517 in the central portion 515. Such arrangement may insure that no etching defects occur near the ends 512 and 514 of the corresponding stator comb plate 503 and rotor comb plate 507.

## Claims

1. A MEMS structure comprising
• a stator (201) which comprises a stator element (202) and a row of stator comb fingers (203), wherein the stator comb fingers extend away from the stator element in a y-direction,
• a rotor (205) which comprises a rotor element (206) and a row of rotor comb fingers (207), wherein the rotor comb fingers extend away from the rotor element in the direction which is opposite to the y-direction,
and wherein
• the stator comb fingers are interdigitated with the rotor comb fingers, and form an interdigitated row (208),
• and each pair of the adjacent stator comb finger and rotor comb finger is separated from each other by a x-gap (209, 220, 221, 222, 223) in a x-direction, which is perpendicular to the y-direction,
and wherein
• the interdigitated row comprises an end portion (218),
• and the interdigitated row comprises a central portion (219), and the central portion and the end portion are next to each other,
• and the widths of the x-gaps in the central portion (222, 223) have a constant value,
**characterized in that** the widths of the x-gaps (209, 220, 221) gradually decrease in the end portion (218) of the interdigitated row (208) so that the width of the endmost x-gap (209) in the end portion of the interdigitated row is the largest.

2. The MEMS structure of claim 1, wherein each stator comb finger and the opposite rotor element are separated from each other by a first y-gap (301, 303, 305) in the y-direction, and each rotor comb finger and the opposite stator element are separated from each other by a second y-gap (302, 304, 306) in the y-direction, and the widths of the first and the second y-gaps gradually decrease in the end portion of the interdigitated row, so that the width of the endmost first (301) or second (302) y-gaps in the end portion of the interdigitated row is the largest, and wherein widths of the first and the second y-gaps have a constant value in the central portion (219) of the interdigitated row.

3. The MEMS structure of claim 1 or 2, wherein the interdigitated row comprises a second end portion (401) with at least two last pairs of the adjacent stator comb fingers and rotor comb fingers, and wherein the second end portion is next to the central portion (219), and wherein the widths of the x-gaps (403, 404, 405) gradually decrease in the second end portion of the interdigitated row (208) so that the width of the endmost x-gap (403) in the second end portion (401) of the interdigitated row is the largest.

4. The MEMS structure of claim 3, wherein the widths of the first and the second y-gaps (406, 407, 408, 409, 410, 411) gradually decreases in the second end portion (401) of the interdigitated row (208), so that the width of the endmost first (407) or second (406) y-gap in the second end portion of the interdigitated row is the largest.

5. The MEMS structure according to any preceding claim, wherein a ratio between the largest and the smallest widths of the x-gap is more than 125 %.

6. The MEMS structure according to claims 2-5, wherein a ratio between the largest and the smallest widths of the first and the second y-gap is more than 125 %.

## Patentansprüche

1. MEMS- Struktur umfassend:
• einen Stator (201), der ein Statorelement (202) und eine Reihe von Statorkammfingern (203) umfasst, wobei die Statorkammfinger sich in einer y-Richtung vom Statorelement weg erstrecken,
• einen Rotor (205), der ein Rotorelement (206) und eine Reihe von Rotorkammfingern (207) umfasst, wobei die Rotorkammfinger sich in der entgegengesetzt zur y-Richtung verlaufenden Richtung vom Rotorelement weg erstrecken,
und wobei
• die Statorkammfinger mit den Rotorkammfingern verschränkt sind und eine verschränkte Reihe (208) bilden,
• und jedes Paar aus benachbartem Statorkammfinger und Rotorkammfinger in einer x-Richtung, die rechtwinklig zur y-Richtung ist, über einen x-Spalt (209, 220, 221, 222, 223) voneinander getrennt ist,
und wobei
• die verschränkte Reihe einen Endabschnitt (218) umfasst,
• und die verschränkte Reihe einen Mittelabschnitt (219) umfasst, und der Mittelabschnitt und der Endabschnitt nebeneinander liegen,
• und die Weiten der x-Spalte im Mittelabschnitt (222, 223) einen konstanten Wert aufweisen,
**gekennzeichnet dadurch, dass** die Weiten der x-Spalte (209, 220, 221) im Endabschnitt (218) der verschränkten Reihe (208) graduell abnehmen, so dass die Weite des äußersten x-Spalts (209) im Endabschnitt der verschränkten Reihe am größten ist.

2. MEMS-Struktur nach Anspruch 1, wobei jeder Statorkammfinger und das gegenüberliegende Rotorelement über einen ersten y-Spalt (301, 303, 305) in der y-Richtung voneinander getrennt sind, und jeder Rotorkammfinger und das gegenüberliegende Statorelement über einen zweiten y-Spalt (302, 304, 306) in der y-Richtung voneinander getrennt sind, und die Weiten der ersten und der zweiten y-Spalte im Endabschnitt der verschränkten Reihe graduell abnehmen, so dass die Weite des äußersten ersten (301) oder zweiten (302) y-Spalts im Endabschnitt der verschränkten Reihe am größten ist, und wobei die Weiten der ersten und der zweiten y-Spalte im Mittelabschnitt (219) der verschränkten Reihe einen konstanten Wert aufweisen.

3. MEMS-Struktur nach Anspruch 1 oder 2, wobei die verschränkte Reihe einen zweiten Endabschnitt (401) mit mindestens zwei letzten Paaren aus angrenzenden Statorkammfingern und Rotorkammfingern umfasst, und wobei der zweite Endabschnitt neben dem Mittelabschnitt (219) liegt, und wobei die Weiten der x-Spalte (403, 404, 405) im zweiten Endabschnitt der verschränkten Reihe (208) graduell abnehmen, so dass die Weite des äußersten x-Spalts (403) im zweiten Endabschnitt (401) der verschränkten Reihe am größten ist.

4. MEMS-Struktur nach Anspruch 3, wobei die Weiten der ersten und der zweiten y-Spalte (406, 407, 408, 409, 410, 411) im zweiten Endabschnitt (401) der verschränkten Reihe (208) graduell abnehmen, so dass die Weite des äußersten ersten (407) oder zweiten (406) y-Spalts im zweiten Endabschnitt der verschränkten Reihe am größten ist.

5. MEMS-Struktur nach einem vorhergehenden Anspruch, wobei ein Verhältnis zwischen der größten und der kleinsten Weite des x-Spalts größer als 125 % ist.

6. MEMS-Struktur nach Anspruch 2 bis 5, wobei ein Verhältnis zwischen der größten und der kleinsten Weite des ersten und des zweiten y-Spalts größer als 125 % ist.

## Revendications

1. Structure MEMS comprenant
• un stator (201) qui comprend un élément statorique (202) et une rangée de doigts de peigne statoriques (203), les doigts de peigne statoriques s'étendant à partir de l'élément statorique dans une direction y,
• un rotor (205) qui comprend un élément rotorique (206) et une rangée de doigts de peigne rotoriques (207), les doigts de peigne rotoriques s'étendant à partir de l'élément rotorique dans la direction qui est opposée à la direction y,
et dans lequel
• les doigts de peigne statoriques s'interdigitent avec les doigts de peigne rotoriques et forment une rangée interdigitée (208),
• et chaque paire de doigt de peigne statorique et doigt de peigne rotorique adjacents est séparée l'une de l'autre par un espace x (209, 220, 221, 222, 223) dans une direction x qui est perpendiculaire à la direction y,
et dans lequel
• la rangée interdigitée comprend une partie terminale (218),
• et la rangée interdigitée comprend une partie centrale (219), et la partie centrale et la partie terminale sont l'une à côté de l'autre,
• et les largeurs de l'espace x dans la partie centrale (222, 223) ont une valeur constante,
**caractérisé en ce que** les largeurs des espaces x (209, 220, 221) diminuent graduellement dans la partie terminale (218) de la rangée interdigitée (208) de telle sorte que la largeur de l'espace d'extrémité x (209) dans la partie terminale de la rangée interdigitée est la plus grande.

2. Structure MEMS selon la revendication 1, dans lequel chaque doigt de peigne statorique et l'élément rotorique opposé sont séparés l'un de l'autre par un premier espace y (301, 303, 305) dans la direction y, et chaque doigt de peigne rotorique et l'élément statorique opposé sont séparés l'un de l'autre par un deuxième espace y (302, 304, 306) dans la direction y, et les largeurs des premiers et deuxièmes espaces y diminuent graduellement dans la partie terminale de la rangée interdigitée de telle sorte que la largeur des premier (301) et deuxième (302) espaces d'extrémité y dans la partie terminale de la rangée interdigitée est la plus grande, et dans lequel les largeurs des premiers et deuxièmes espaces y dans la partie centrale (219) de la rangée interdigitée ont une valeur constante.

3. Structure MEMS selon la revendication 1 ou 2, dans lequel la rangée interdigitée comprend une deuxième partie terminale (401) avec au moins deux dernières paires des doigts de peigne statoriques et doigts de peine rotoriques adjacents, et dans lequel la deuxième partie terminale est située à côté de la partie centrale (219), et dans lequel les largeurs des espaces x (403, 404, 405) diminuent graduellement dans la deuxième partie terminale de la rangée interdigitée (208) de telle sorte que la largeur de l'espace d'extrémité x (403) dans la deuxième partie terminale (401) de la rangée interdigitée est la plus grande.

4. Structure MEMS selon la revendication 3, dans lequel les largeurs des premiers et deuxièmes espaces y (406, 407, 408, 409, 410, 411) diminuent graduellement dans la deuxième partie terminale (401) de la rangée interdigitée (208) de telle sorte que la largeur du premier (407) ou deuxième (406) espace d'extrémité y dans la deuxième partie terminale de la rangée interdigitée est la plus grande.

5. Structure MEMS selon une revendication précédente quelconque, dans lequel un rapport entre la plus grande largeur et la plus petite largeur de l'espace x est supérieur à 125 %.

6. Structure MEMS selon la revendication 2 à 5, dans lequel un rapport entre la plus grande largeur et la plus petite largeur des premier et deuxième espaces y est supérieur à 125 %.
